Europäisches Patentamt

European Patent Office

Office européen des brevets

(11) Numéro de publication : **0 378 459 B1**

(12) **FASCICULE DE BREVET EUROPEEN**

(45) Date de publication du fascicule du brevet :
16.03.94 Bulletin 94/11

(51) Int. Cl.$^5$ : **G01J 5/20, H01L 39/10**

(21) Numéro de dépôt : **90400035.3**

(22) Date de dépôt : **05.01.90**

---

(54) **Détecteur de rayonnement.**

---

(30) Priorité : **13.01.89 FR 8900373**

(43) Date de publication de la demande :
**18.07.90 Bulletin 90/29**

(45) Mention de la délivrance du brevet :
**16.03.94 Bulletin 94/11**

(84) Etats contractants désignés :
**DE GB IT NL**

(56) Documents cités :
**FR-A- 854 913**
**US-A- 2 932 743**
**US-A- 3 077 538**

(56) Documents cités :
**JAPANESE JOURNAL OF APPLIED PHYSICS, part 2, vol. 26, supplément 26-3, 1987, pages 1145-1146, Tokyo, JP; Y. ENOMOTO et al.: "Far infrared detector using boundary Josephson junctions"**
**INSTRUMENTS AND EXPERIMENTAL TECHNIQUES, vol. 27, no. 4, partie 1, juillet-août 1984, pages 781-804, Plenum Publishing Corp., New York, US; I.A. KHREBTOV: "Superconducting bolometers (review)"**

(73) Titulaire : **THOMSON-CSF**
**173, Boulevard Haussmann**
**F-75008 Paris (FR)**

(72) Inventeur : **Hartemann, Pierre**
**THOMSON-CSF SCPI Cédex 67**
**F-92045 Paris la Défense (FR)**

(74) Mandataire : **Grynwald, Albert et al**
**THOMSON-CSF, SCPI, B.P. 329, 50, rue Jean-Pierre Timbaud**
**F-92402 Courbevoie Cédex (FR)**

## Description

L'invention a pour objet un détecteur de rayonnement notamment un détecteur de rayonnement dont l'élément sensible est réalisé en matériau supraconducteur.

Plus particulièrement, l'invention concerne des configurations d'ensembles d'éléments sensibles en supraconducteurs de structure granulaire permettant d'obtenir des images en rayonnement incohérent, de longueur d'onde située dans la gamme comprise entre les longueurs d'ondes visibles et les ondes millimétriques.

Le matériau supraconducteur peut présenter une haute température critique et être utilisé notamment dans un domaine de température s'étendant de 77 k (azote liquide) à 27 K (néon liquide).

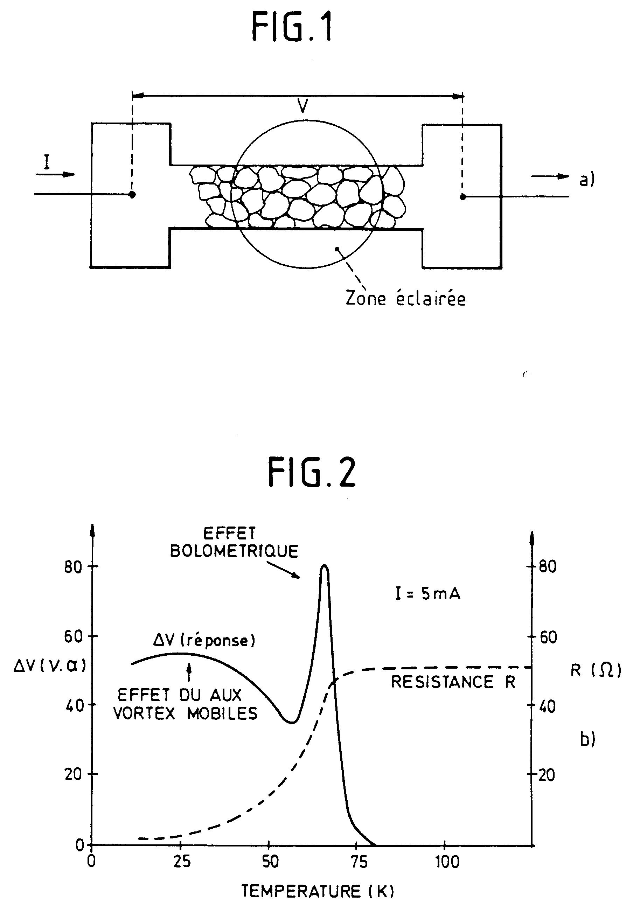

Un élément planaire en supraconducteur granulaire 1 tel que représenté en figure 1 traversé par un courant I et éclairé par un spot de rayonnement dont la longueur d'onde est comprise entre une longueur d'onde visible et une longueur d'onde millimétrique voit sa résistance changer localement.

L'interaction entre le supraconducteur et le rayonnement incident s'effectue suivant deux processus physiques selon que la longueur d'onde est inférieure à quelques dizaines de micromètres environ ou selon que la longueur d'onde est supérieure à quelques dizaines de micromètres.

Si la longueur d'onde du rayonnement éclairant le matériau supraconducteur 1 de la figure 1 est inférieure à quelques dizaines de micromètres, l'énergie des photons est suffisante pour briser les paires de Cooper en quasiparticules qui diffusent dans les grains et se recombinent. Deux types de phénomènes peuvent être observés :

a) Les populations de paires de Cooper et quasiparticules sont en état d'équilibre : le rayonnement échauffe l'élément supraconducteur (effet bolométrique représenté par la zone "a" de la courbe $\Delta V$ en fonction de la température de la figure 2). La largeur de la bande interdite du supraconducteur diminue quand la température croît.

b) Les populations de paires et de quasiparticules sont en état de déséquilibre. La largeur de la bande interdite est réduite d'une valeur proportionnelle à l'excès de quasiparticules (zone "b" de la courbe $\Delta V$ en fonction de la température de la figure 2).

Dans un supraconducteur granulaire les joints de grains constituent des barrières de jonctions Josephson. Quand la largeur de la bande interdite est diminuée, la densité de courant critique des jonctions intergranulaires est réduite et devient inférieure à la densité de courant fourni. Dans ces conditions le champ magnétique pénètre dans les espaces granulaires sous forme de vortex qui se déplacent sous l'effet de la force de Lorentz en dissipant de la puissance. Un rayonnement induit donc une photorésistance dans la zone éclairée et l'amplitude de la réponse est proportionnelle au nombre de vortex mobiles. La figure 2 montre, à titre d'exemple, la réponse en fonction de la température. Les deux types de réponse "a" et "b" sont clairement distingués.

Si la longueur d'onde du rayonnement éclairant le matériau supraconducteur 1 est supérieure à quelques dizaines de micromètres, l'énergie des photons est inférieure à la largeur de la bande interdite. Cependant les courants compensant le champ magnétique sont supérieurs aux courants critiques des jonctions intergranulaires et le champ magnétique pénètre dans les jonctions sous forme de vortex qui se déplacent en dissipant de la puissance.

L'invention met en application ce phénomène d'induction d'une photorésistivité (dans un matériau supraconducteur, sous l'effet d'un éclairement par un rayonnement.

Un tel détecteur élémentaire présente l'avantage par rapport aux détecteurs photoconducteurs connus de permettre une réalisation d'éléments sensibles de détection ayant des dimensions plus réduites. En effet, dans les dispositifs selon l'invention, la partie sensible est limitée à la partie éclairée par le faisceau de rayonnement à détecter, alors que dans les photoconducteurs, il y a étalement de la zone sensible par rapport à la zone éclairée comme on le verra ultérieurement.

De plus, certaines réalisations selon l'invention permettent un fonctionnement sans dissipation électrique dans l'obscurité ce qui n'est pas le cas des dispositifs photoconducteurs.

Le dispositif de l'invention permet d'obtenir des détecteurs de grandes surfaces et de fonctionner dans une large gamme de longueurs d'ondes.

L'invention concerne donc un détecteur de rayonnement caractérisé en ce qu'il comprend :

- au moins un élément en matériau supraconducteur présentant des propriétés de photorésistance et sensible à un éclairement induisant un effet de photorésistivité dans le matériau supraconducteur ;

- une source électrique connectée aux bornes de l'élément en matériau supraconducteur ;

- un dispositif de mesure de la résistance de l'élément en matériau supraconducteur connecté à cet élément.

Parmi différents modes de réalisations l'invention concerne plus particulièrement un détecteur caractérisé en ce que :

- la source électrique est une source de courant constant ;

- les entrées différentielles d'un amplificateur différentiel sont connectées aux bornes de l'élément supraconducteur, l'amplificateur fournissant un signal représentant la valeur de la résistance de l'élément supraconducteur.

Ainsi qu'un détecteur caractérisé en ce qu'il comporte une série d'éléments supraconducteurs connectée en série, un amplificateur différentiel étant associé à chaque élément supraconducteur, et qu'il comporte un dispositif à transfert de charge, une sortie de chaque amplificateur étant connectée à un étage du dispositif à transfert de charge qui permet d'addionner les signaux fournis par les différents amplificateurs différentiels.

Les différents objets et caractéristiques de l'invention apparaîtront plus clairement dans la description qui va suivre faite à titre d'exemple en se reportant aux figures annexées qui représentent :

- la figure 1, un élément supraconducteur permettant d'illustrer des phénomènes décrits précédemment ;
- la figure 2, des courbes de réponse décrites précédemment ;
- la figure 3, un exemple de réalisation slmplifié d'un détecteur élémentaire de rayonnement selon l'invention ;
- la figure 4, un exemple de réalisation d'un ensemble de détecteurs selon l'invention alimenté à tension constante ;
- la figure 5, un exemple de réalisation d'un ensemble de détecteurs selon l'invention alimenté à courant constant ;
- la figure 6, un exemple de réalisation préféré d'un détecteur selon l'invention ;
- la figure 7, un exemple de réalisation matricielle du détecteur selon l'invention ;
- la figure 8, un autre exemple de réalisation matricielle du détecteur selon l'invention ;
- la figure 9, une variante de réalisation de l'invention comportant des éléments de filtrage ;
- la figure 10, une variante de réalisation de l'invention comportant une couche de masquage.

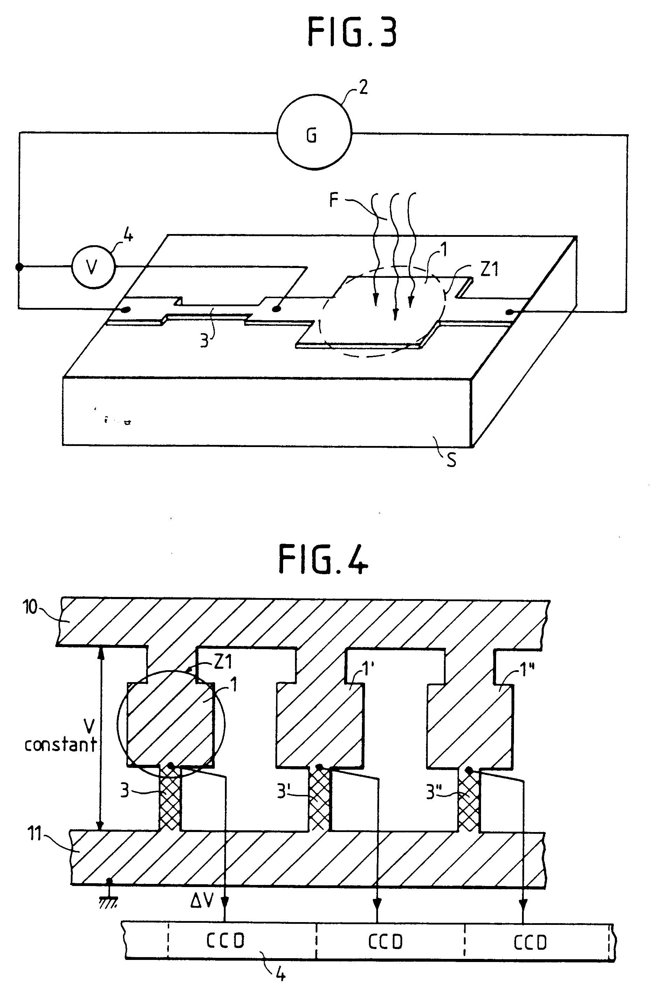

En se reportant à la figure 3, on va décrire un exemple de réalisation slmplifié d'un détecteur de rayonnement selon l'invention.

Ce détecteur comporte sur un substrat S un élément 1 en matériau supraconducteur. Un générateur électrique 2 est connecté à cet élément 1. Des moyens constitués par une résistance de valeur constante 3 et un dispositif de mesure de tension 4 sont couplés à l'élément pour mesurer la résistance de l'élément 1. Selon l'exemple de la figure 3, le générateur 2 est une source de tension constante. La résistance 3 est réalisée sous forme d'une couche résistive connectée en série avec l'élément 1. Cette couche résistive peut être en même matériau supraconducteur que l'élément 1 mais il présente alors (en raison de son rétrécissement) une densité de courant supérieure la valeur critique. Le dispositif de mesure de tension est connecté aux bornes de la résistance 3.

L'élément 1 est éclairé par un faisceau de rayonnement F qui projette sur une zone $Z_1$, indiquée en trait mixte sur la figure 1, un spot d'éclairement.

Comme décrit précédemment, cet éclairement induit un effet de photorésistivité dans l'élément supraconducteur 1. La résistance de celui-ci varie. Le courant délivré par la source de tension constante 2 varie. Le dispositif de mesure de tension 4 mesure la tension aux bornes de la résistance constante 3 et donc du courant circulant dans l'élément 1 et par suite indique une valeur de la forme :

$$\frac{Vo}{R3 + R_p}$$

où :

- $V_o$ est la tension de la source de tension
- R3 la valeur de la résistance 3
- $R_p$ la résistance de l'élément éclairée dont la valeur traduit l'intensité du rayonnement reçu par l'élément supraconducteur 1

Cette valeur de résistance $R_p$ traduit donc l'intensité du rayonnement reçu dans la zone $Z_1$.

La figure 4 représente un exemple de réalisation comportant une série de détecteurs mettant en oeuvre le dispositif de la figure 3.

Sur un substrat est réalisée une série d'éléments 1, 1', 1" en matériau supraconducteur. A chaque élément en matériau supraconducteur est associée en série une résistance 3, 3', 3".

Les éléments 1, 1', 1" et les résistances 3, 3', 3" sont connectés en parallèle par des conducteurs 10 et 11 aux bornes d'une source à tension constante non représentée.

Les éléments 1, 1', 1", les résistances 3, 3', 3" et les conducteurs 10 et 11 sont réalisés sous forme de couches sur un substrat.

Les éléments 1, 1', 1" étant en matériau supraconducteur, les conducteurs 10 et 11 sont de préférence également en matériau supraconducteur. Les résistances 3, 3', 3" sont soit en matériau métallique non supraconducteur (conducteur normal), soit en matériau supraconducteur à densité de courant supérieure à la densité de courant critique.

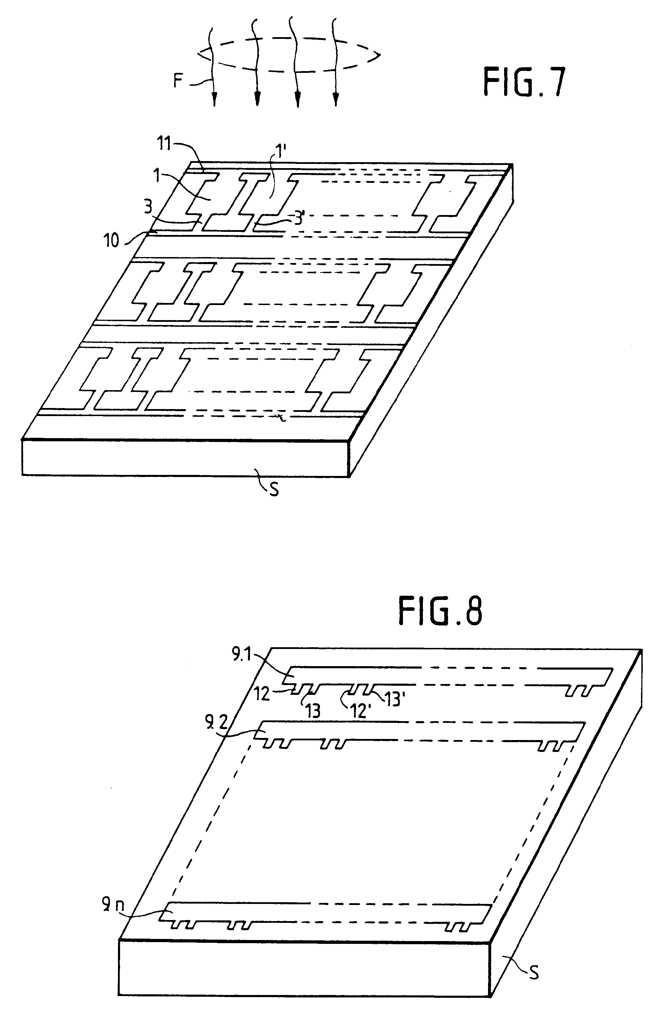

Des dispositifs de mesure de tension sont associés à chaque résistance 3, 3', 3" et mesurent chacun l'intensité du rayonnement reçu dans une zone $Z_1$ du détecteur. En prévoyant plusieurs lignes de détecteurs, voire plusieurs centaines de lignes, on obtient une matrice de détecteurs, telle que représentée en figure 7, qui permet de recevoir une image, chaque élément supraconducteur permettant de détecter un élément d'image.

Selon l'exemple de réalisation de la figure 4, à chaque rangée d'éléments supraconducteurs (1, 1', 1") et de résistances (3, 3', 3") est associée une barrette d'un dispositif à transfert de charge 4. A chaque résistance 3, 3', 3" est couplé un étage CCD, CCD', CCD" du dispositif à transfert de charge 4.

Par des moyens non représentés, un élément d'image à détecter balaye la rangée d'éléments supraconducteurs 1, 1', 1", c'est-à-dire est transmis successivement à ces éléments. Les différents étages CCD, CCD', CCD'' du dispositif à transfert de charge 4 détectent donc chacun cet élément d'image. Le dispositif à transfert de charge intègre les valeurs enregistrées par les différents étages CCD à CCD'' et fournit une valeur de détection pour chaque élément d'image.

Un tel dispositif peut être réalisé aisément en prévoyant que les éléments supraconducteurs 1, 1', 1'' et les résistances 3, 3', 3'' soient faits à la surface d'un dispositif transfert de charge de façon monolithique, le dispositif transfert de charge tenant la place du substrat de la figure 3 et les éléments en matériau supraconducteur étant déposés directement sur un substrat silicium.

Un tel dispositif peut également fonctionner de façon statique. Dans ce cas, chaque élément supraconducteur permet de détecter chaque instant un élément d'image. A chaque résistance associée à un élément supraconducteur est couplé un dispositif de mesure de tension non représenté au lieu d'un étage d'un dispositif à transfert de charge. Chaque dispositif de mesure de tension fournit à chaque instant une indication sur l'intensité du rayonnement reçu par un élément supraconducteur. A chaque instant, l'ensemble des dispositifs de mesure de tension détecte une image véhiculée par le faisceau de rayonnement reçu par l'ensemble des éléments supraconducteurs.

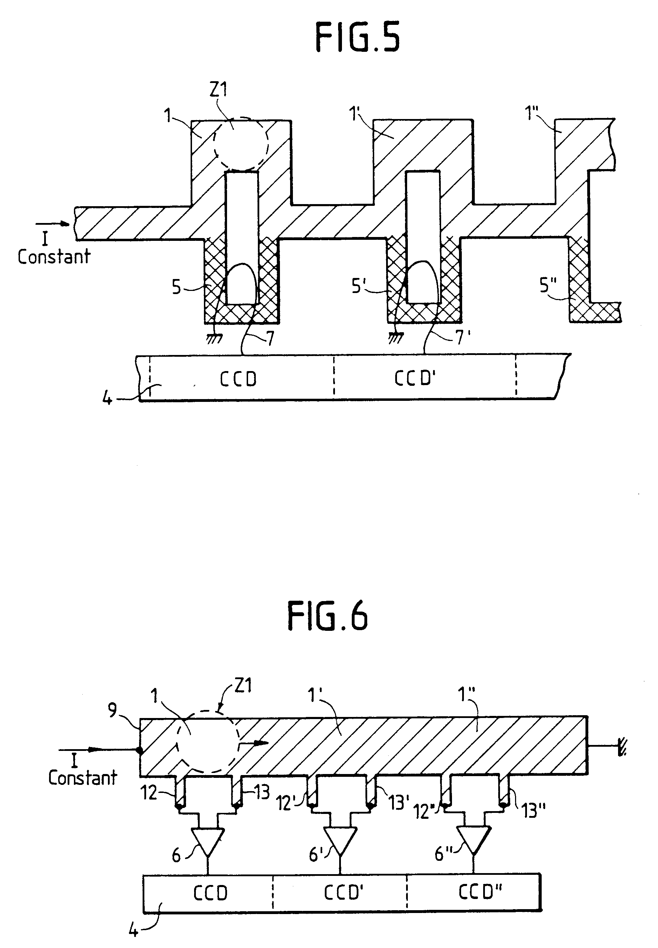

La figure 5 représente un exemple de réalisation de l'invention dans lequel le générateur électrique est une source de courant constant.

Une rangée d'éléments supraconducteurs 1, 1', 1'' est alimentée en série par une source, non représentée, fournissant un courant I constant. Aux bornes de chaque élément 1, 1', 1'' est connectée en parallèle une résistance 5, 5', 5''. Un dispositif permet de mesurer l'intensité du courant dans chaque résistance 5, 5', 5''. Selon l'exemple de réalisation de la figure 5, on prévoit une boucle de couplage (7, 7') associée à chaque résistance (5, 5') et permettant de détecter l'intensité du courant dans chaque résistance (5, 5'). Chaque boucle de couplage est connectée à un étage CCD, CCD' d'une barrette d'un dispositif à transfert de charge 4. On peut également prévoir à la place de chaque boucle de couplage, un amplificateur différentiel dont les entrées différentielles sont connectées aux bornes d'une résistance (5, 5', 5'') et la sortie à un étage (CCD, CCD') du dispositif à transfert de charge 4.

Par des moyens non représentés, un élément d'image balaye les différents éléments supraconducteurs 1, 1', 1''. A chaque passage d'un spot de rayonnement $(Z_1)$ sur un élément supraconducteur (1), l'étage (CCD) correspondant enregistre une valeur de détection correspondant à l'intensité du spot $(Z_1)$. Après balayage des éléments supraconducteurs 1, 1', 1'' d'une rangée, le dispositif à transfert de charge intègre les différentes valeurs enregistrées et fournit une valeur de l'intensité du spot de rayonnement détecté. L'élément d'image suivant peut ensuite être détecté.

Comme précédemment, une rangée d'éléments supraconducteurs et les résistances associées peuvent être réalisées sur un dispositif à transfert de charge pour fournir une réalisation monolithique. Le dispositif de la figure 5 peut être également réalisé sous une forme matérielle similaire à la structure de la figure 7.

Le dispositif de la figure 5 peut fonctionner de façon statique en prévoyant, associé à chaque résistance 5, 5', 5'', un dispositif de mesure du courant circulant dans chaque résistance. Un ensemble d'éléments supraconducteurs détecte donc à chaque instant une image véhiculée par un faisceau de rayonnement éclairant cet ensemble d'élément supraconducteur.

La figure 6 représente un exemple de réalisation préféré du dispositif de l'invention.

Ce dispositif comprend un ruban 9 en matériau supraconducteur. Ce ruban 9 est muni de couples de prises de contact 12 - 13, 12' - 13', 12'' - 13''. La partie de ruban 9 comprise entre deux contacts d'un couple, 12 et 13 par exemple, délimite l'équivalent d'un élément supraconducteur (1 selon l'exemple pris) te que désigné précédemment.

Les deux entrées différentielles d'un amplificateur différentiel sont connectées aux contacts d'un couple de prises de contacts. On a donc ainsi un amplificateur différentiel 6 connecté aux contacts 12 et 13.

La sortie de chaque amplificateur différentiel (6, 6', 6'') est connecté à un étage (CCD, CCD', CCD'') d'une barrette d'un dispositif à transfert de charge.

Le ruban 9 en matériau supraconducteur est alimenté par une source à courant constant non représentée.

Lorsqu'un élément d'image éclaire par un spot $(Z_1)$ un élément supraconducteur (1), la résistance de cet élément varie. L'amplificateur différentiel 6 détecte cette variation et fournit, à un étage (CCD) du dispositif à transfert de charge 4, une information correspondante.

Le spot correspondant à un même élément d'image balaye le ruban 9 et passe successivement sur les éléments supraconducteurs 1, 1', 1''. Comme cela a été décrit précédemment, la détection d'un élément image par les différents éléments supraconducteurs est intégrée par le dispositif à transfert de charge qui fournit une valeur représentant l'intensité du spot détecté.

Comme dans les exemples de réalisation précédents, le dispositif de la figure 6 peut être intégré sur une barrette d'un dispositif à transfert de charge. Dans ce cas les amplificateurs 6, 6', 6'' sont eux mêmes également intégrés sur le dispositif à transfert de charge. On peut également prévoir une réalisation sous forme matricielle. On obtient alors un détecteur matriciel représenté en figure 8 et comportant n rubans de lignes 9.1 à 9.n. Chaque ruban de ligne est conçu comme le dispositif de la figure 6 et comporte des prises de contacts telles que 12 - 13. L'ensemble est réalisé sur un substrat semiconducteur comportant les amplificateurs différentiels et des lignes de dispositifs à transfert de charge, à chaque ligne de dispositif à transfert de charge correspondant un ruban de ligne.

Enfin, le dispositif peut fonctionner de manière statique, sans utilisation de dispositif à transfert de charge, les sorties des amplificateurs différentiels étant alors reliées directement à des dispositifs permettant d'enregistrer l'ensemble des informations fourni par l'ensemble d'éléments supraconducteurs.

On remarque que dans le mode de réalisation de la figure 4, en absence de détection de rayonnement (obscurité), le dispositif dissipe de l'énergie électrique. Au contraire, dans les modes de réalisation des figures 5 et 6, avec une source à courant constant, en absence de rayonnement, la résistance globale de chaque rangée est nulle (ou quasi-nulle) et le dispositif ne consomme pas d'énergie.

Selon une variante de réalisation de l'invention, on prévoit sur les éléments supraconducteurs (1, 1', 1") une couche filtrante permettant la transmission, aux éléments supraconducteurs, des rayonnements d'une fréquence sélectionnée ou d'une fréquence comprise dans une gamme réduite de fréquence.

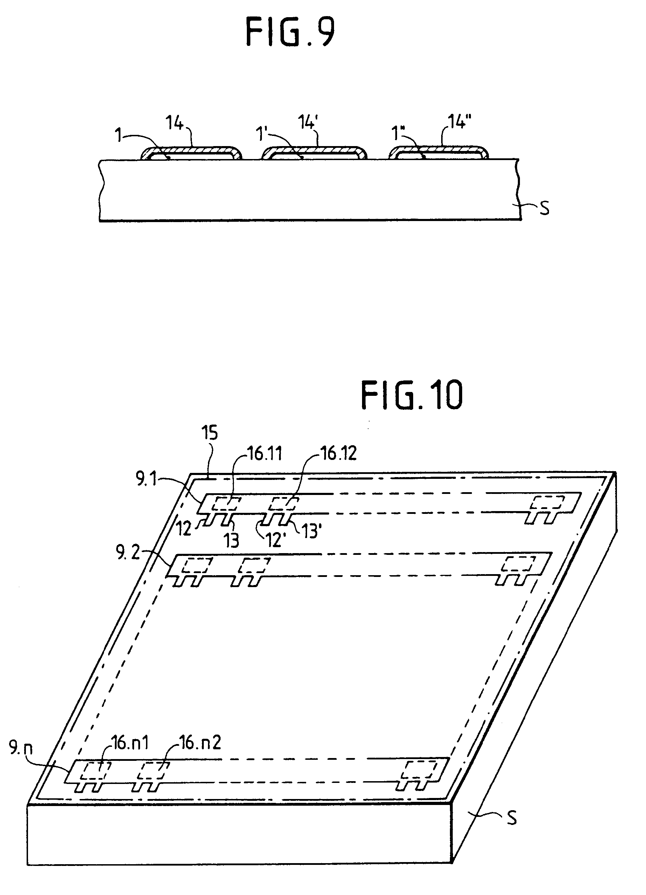

Selon l'invention, on prévoit également, comme cela est représenté en figure 9, sur les éléments supraconducteurs 1, 1', 1", des couches filtrantes 14, 14', 14" de natures différentes permettant aux éléments supraconducteurs de détecter des rayonnements de fréquences différentes.

Une telle disposition appliquée à une rangée d'éléments supraconducteurs) telle que représentée en figures 4, 5 ou 6, conduit à avoir des éléments supraconducteurs d'une même rangée détectant des fréquences différentes. Dans ce cas on préférera un fonctionnement statique d'un tel dispositif. Comme cela a été décrit précédemment, on associera à chaque élément supraconducteur un dispositif de mesure de résistance de telle façon qu'à chaque instant, l'ensemble de ces dispositifs de mesure détecte une image véhiculée par un faisceau de rayonnements, de fréquences différentes, reçu par l'ensemble des éléments supraconducteurs.

Dans le cas d'une structure matricielle telle que représentée en figures 7 ou 8, on prévoit que les éléments supraconducteurs d'une même rangée sont recouverts par des couches filtrantes identiques de telle façon que les éléments supraconducteurs de cette rangée soient sensibles à une même fréquence (ou une même gamme de fréquence). Dans ce cas on pourra recouvrir différentes rangées d'éléments supraconducteurs par des couches de matériaux différents. Plus pratiquement, on prévoira sur les rangées d'éléments supraconducteurs des bandes de filtrage optique.

Dans une telle disposition matricielle, le fonctionnement avec des dispositifs à transfert de charge associés aux éléments supraconducteurs de chaque rangée est alors envisagée puisque les éléments d'une même rangée détectent les mêmes fréquences.

Enfin, selon une autre variante de réalisation, l'invention prévoit sur les dispositifs tels que décrits précédemment une couche de masquage présentant des ouvertures délimitant, sur les éléments supraconducteurs de ces dispositifs, des zones actives, de telle façon que cette couche de masquage permet au faisceau à détecter d'atteindre ces zones actives tandis qu'elle masque le reste de ces dispositifs.

Cette disposition est particulièrement intéressante pour un dispositif du type décrit précédemment, en relation avec les figures 6 et 8, où les éléments supraconducteurs sont réalisés sous forme d'un ruban 9 et où, dans un fonctionnement dynamique, un spot de rayonnement à détecter balaie chaque ruban.

Sur la figure 10, on a représenté un détecteur matriciel du même type que celui de la figure 8 avec, en trait mixte, une couche de masquage 15 présentant des ouvertures 16.11, 16.12, ... 16.n1, 16.n2 à l'emplacement des éléments supraconducteurs de détection.

Une telle couche de masquage permet de s'affranchir de la précision de la dimension du spot de rayonnement reçu par chaque élément supraconducteur. La surface sensible de chaque élément supraconducteur a des dimensions déterminées et, il suffit que les dimensions de chaque spot de rayonnement soient supérieures à celle de chaque ouverture de la couche de masquage.

On peut également combiner une couche de masquage et des couches filtrantes sur les éléments supraconducteurs. Par exemple, on peut prévoir une couche de masquage possédant des ouvertures à l'emplacement des éléments supraconducteurs et de munir chaque ouverture d'une couche filtrante. Ou bien, on peut superposer une couche de masquage aux couches filtrantes ou inversement.

Dans les structures selon l'invention, la photorésistivité induite par le rayonnement incident présente des avantages importants par rapport à la photoconductivité des semiconducteurs :

- la partie active de l'élément supraconducteur 1 reste circonscrite à la zone éclairée sans l'étalement important observé avec les photoconducteurs. Cet élargissement est attribué au déplacement, sous l'effet du champ électrique, des porteurs créés par le rayonnement pendant leur temps de vie. Donc, avec les supraconducteurs, on peut rapprocher les éléments sensibles en évitant les interactions et intégrer le signal sur un grand nombre de détecteurs élémentaires ;
- la longueur des lignes peut être grande car il est relativement facile de déposer des couches supraconductrices sur des grandes surfaces et le nombre de détecteurs coopérant par ligne peut être très élevé ;
- les dispositifs selon l'invention peuvent fonctionner en infrarouge et en ondes millimétriques ;
- De plus, dans les structures des figures 6 et 7 aucune dissipation de puissance n'existe en obscurité ce qui n'est pas le cas avec les photoconducteurs.

Il est bien évident que la description qui précède n'a été faite qu'à titre d'exemple non limitatif et que d'autres variantes peuvent être envisagées sans sortir du cadre de l'invention. Les exemples numériques et la nature des matériaux indiqués n'ont été fournis que pour illustrer la description.

## Revendications

1. Détecteur de rayonnement, caractérisé en ce qu'il comprend :
   - au moins un élément en matériau supraconducteur (1) présentant des propriétés de photorésistance et sensible à un éclairement induisant un effet de photorésistivité dans le matériau supraconducteur ;
   - une source électrique (2) connectée aux bornes de l'élément en matériau supraconducteur (1) ;
   - un dispositif de mesure de la résistance de l'élément (1) en matériau supraconducteur connecté à cet élément.

2. Détecteur selon la revendication 1, caractérisé en ce que :
   - la source électrique (2) est source à tension constante ;
   - le dispositif de mesure de la résistance de l'élément supraconducteur (1) comporte un élément résistif (3) connecté en série avec l'élément supraconducteur (1) et un dispositif de mesure de tension (4) connecté à cet élément résistif (3) et mesurant la tension aux bornes de l'élément résistif (3).

3. Détecteur selon la revendication 1, caractérisé en ce que :
   - la source électrique (2) est une source de courant constant ;
   - le dispositif de mesure de la résistance de l'élément supraconducteur (1) comporte un élément résistif (5) connecté en parallèle avec l'élément supraconducteur (1) et un dispositif de mesure (4) couplé audit élément résistif (5) et mesurant le courant circulant dans cet élément résistif.

4. Détecteur selon la revendication 1, caractérisé en ce que :
   - la source électrique (2) est une source de courant constant ;
   - les entrées différentielles d'un amplificateur différentiel (6, 6', 6") sont connectées aux bornes de l'élément supraconducteur, l'amplificateur fournissant un signal représentant la valeur de la résistance de l'élément supraconducteur.

5. Détecteur selon la revendication 1, caractérisé en ce que l'élément en matériau supraconducteur (1) est réalisé sous forme d'une couche sur un substrat (S).

6. Détecteur selon la revendication 5, caractérisé en ce que l'élément en matériau supraconducteur (1) possède des connexions réalisées en couches sur le substrat et que les éléments résistifs (3, 5) sont également réalisés en couches sur le même substrat (S).

7. Détecteur selon la revendication 6, caractérisé en ce que les éléments résistifs (3, 5) et les connexions sont réalisés en matériau supraconducteur de même nature que l'élément en matériau supraconducteur (1).

8. Détecteur selon la revendication 1, caractérisé en ce qu'il comporte au moins une rangée d'éléments en matériau supraconducteur (1, 1', 1") connectés en parallèle aux sorties d'alimentation du générateur (2) qui est alors une source de tension constante, une résistance (3, 3', 3") étant associée en série avec chaque élément en matériau supraconducteur (1, 1', 1").

9. Détecteur selon la revendication 1, caractérisé en ce qu'il comporte au moins une rangée d'éléments en matériau supraconducteur (1, 1', 1") connectés en série et alimentés par le générateur (2) qui est alors une source à courant constant, une résistance (5, 5', 5") étant associée en parallèle à chaque élément en matériau supraconducteur (1, 1', 1") un dispositif mesurant le courant circulant dans chacune de ces résistances (5, 5', 5").

10. Détecteur selon l'une des revendications 8 ou 9, caractérisé en ce qu'un dispositif à transfert de charge (4) est associé à chaque ensemble de résistance (3 à 3", 5 à 5") de telle façon qu'à chaque résistance est couplé un étage (CCD, CCD', CCD") du dispositif à transfert de charge, l'association d'une résistance et d'un étage du dispositif à transfert de charge permettant de détecter la résistance d'un élément supraconducteur (1, 1', 1") et par suite de détecter l'intensité du rayonnement reçu par cet élément supraconducteur.

11. Détecteur selon la revendication 4, caractérisé en ce qu'il comporte une rangée d'éléments supraconducteurs connectés en série, un amplificateur différentiel étant associé à chaque élément supraconducteur, et qu'il comporte un dispositif à transfert de charge, une sortie de chaque amplificateur étant connectée à un étage du dispositif à transfert de charge qui additionne les signaux fournis par les différents amplificateurs différentiels.

12. Détecteur selon la revendication 6, caractérisé en ce que le substrat est un semiconducteur permettant d'associer des circuits électroniques de traitement de signal.

13. Détecteur selon l'une des revendications 10 ou 11, caractérisé en ce qu'il comporte une pluralité de rangées d'éléments supraconducteurs de façon à constituer une structure matricielle.

14. Détecteur selon la revendication 1, caractérisé en ce que l'élément en matériau supraconducteur (1) est recouvert d'une couche d'un matériau de filtrage transparent à une fréquence rayonnement ou gamme de fréquences déterminée.

15. Détecteur selon l'une des revendications 8 ou 9, caractérisé en ce que les éléments supraconducteurs (1) sont recouverts de couches de matériau de filtrage différents, différents éléments supraconducteurs étant ainsi sensibles à des fréquences ou des gammes de fréquences différentes.

16. Détecteur selon la revendication 13, caractérisé en ce que chaque rangée d'éléments supraconducteurs est recouverte par une couche d'un matériau de filtrage d'une nature déterminée.

17. Détecteur selon la revendication 1, caractérisé en ce qu'il comporte une couche (15) d'un matériau opaque ou rayonnement recouvrant partiellement l'élément supraconducteur (1) et possédant une ouverture (16.11 à 16 n2) déterminant sur l'élément supraconducteur une zone sensible de détection.

18. Détecteur selon la revendication 13, caractérisé en ce qu'il comporte une couche 15 recouvrant la structure matricielle et possédant une ouverture (16.11 à 16.n2) à l'emplacement de chaque élément supraconducteur.

19. Détecteur selon la revendication 1, caractérisé en ce que le matériau supraconducteur (1) possède des jonctions intergranulaires.

**Patentansprüche**

1. Strahlungsdetektor, dadurch gekennzeichnet, daß er aufweist:
   - mindestens ein Element aus supraleitendem Material (1), das die Eigenschaften eines Fotowiderstands besitzt und auf eine Beleuchtung anspricht, die einen Fotowiderstandseffekt im supraleitenden Material induziert,
   - eine elektrische Quelle (2), die an die Klemmen des Elements aus supraleitendem Material (1) angeschlossen ist,
   - eine Vorrichtung zur Messung des Widerstands des Elements (1) aus supraleitendem Material, die an dieses Element angeschlossen ist.

2. Detektor nach Anspruch 1, dadurch gekennzeichnet, daß
   - die elektrische Quelle (2) eine Quelle konstanter Spannung ist,
   - die Vorrichtung zur Messung des Widerstands des supraleitenden Elements (1) ein Widerstandselement (3) in Reihe mit dem supraleitenden Element (1) sowie eine Spannungsmeßvorrichtung (4) enthält, die an das Widerstandselement (3) angeschlossen ist und die Spannung an den Klemmen des Widerstandselements (3) mißt.

3. Detektor nach Anspruch 1, dadurch gekennzeichnet, daß
   - die elektrische Quelle (2) eine Quelle konstanten Stroms ist,
   - die Vorrichtung zur Messung des Widerstands des supraleitenden Elements (1) ein Widerstandselement (5) in Parallelschaltung mit dem supraleitenden Element (1) sowie eine Meßvorrichtung (4) enthält, die an das Widerstandselement (5) gekoppelt ist und den Strom mißt, der in diesem Widerstandselement fließt.

4. Detektor nach Anspruch 1, dadurch gekennzeichnet, daß
   - die elektrische Quelle (2) eine Quelle konstanten Stroms ist,
   - die differentiellen Eingänge eines Differentialverstärkers (6, 6', 6") an die Klemmen des supraleitenden Elements angeschlossen sind, wobei der Verstärker ein Signal liefert, das dem Wert des Widerstands des supraleitenden Elements entspricht.

5. Detektor nach Anspruch 1, dadurch gekennzeichnet, daß das Element aus supraleitendem Material (1) als Schicht auf einem Substrat (S) ausgebildet ist.

6. Detektor nach Anspruch 5, dadurch gekennzeichnet, daß das Element aus supraleitendem Material (1) Anschlüsse enthält, die als Schichten auf dem Substrat ausgebildet sind, und daß die Widerstandselemente (3, 5) ebenfalls als Schichten auf demselben Substrat (S) ausgebildet sind.

7. Detektor nach Anspruch 6, dadurch gekennzeichnet, daß die Widerstandselemente (3, 5) und die Anschlüsse aus einem supraleitenden Material derselben Art bestehen wie das Element aus supraleitendem Material (1).

8. Detektor nach Anspruch 1, dadurch gekennzeichnet, daß er mindestens eine Reihe von Elementen aus supraleitendem Material (1, 1', 1") aufweist, die parallel an die Speiseausgänge der Quelle (2) angeschlossen sind, welche dann eine Quelle konstanter Spannung ist, wobei ein Widerstand (3, 3', 3") in Reihe mit jedem Element aus supraleitendem Material (1, 1', 1") angeordnet ist.

9. Detektor nach Anspruch 1, dadurch gekennzeichnet, daß er mindestens eine Reihe von Elementen aus supraleitendem Material (1, 1', 1") in Serienschaltung enthält, die von der Quelle (2) gespeist werden, die dann eine Quelle konstanten Stroms ist, wobei ein Widerstand (5, 5', 5") parallel zu jedem Element aus supraleitendem Material (1, 1', 1") vorgesehen ist und eine Vorrichtung den Strom mißt, der in jedem dieser Widerstände (5, 5', 5") fließt.

10. Detektor nach einem der Ansprüche 8 oder 9, dadurch gekennzeichnet, daß eine Ladungstransfervorrichtung (4) jeder Einheit von Widerständen (3 bis 3", 5 bis 5") zugeordnet ist, derart, daß an jeden Widerstand eine Stufe (CCD, CCD', CCD") der Ladungstransfervorrichtung gekoppelt ist, wobei die Assoziation eines Widerstands und einer Stufe der Ladungstransfervorrichtung die Erfassung des Widerstandswerts eines supraleitenden Elements (1, 1', 1") und damit die Erfassung der Intensität der von diesem supraleitenden Element empfangenen Strahlung erlaubt.

11. Detektor nach Anspruch 4, dadurch gekennzeichnet, daß er eine Zeile von supraleitenden Elementen in Serienschaltung aufweist, wobei ein Differentialverstärker jedem supraleitenden Element zu geordnet ist, und daß der Detektor eine Ladungstransfervorrichtung enthält und ein Ausgang jedes Verstärkers an eine Stufe der Ladungstransfervorrichtung angeschlossen ist, die die von den verschiedenen Differentialverstärkern gelieferten Signale addiert.

12. Detektor nach Anspruch 6, dadurch gekennzeichnet, daß das Substrat aus einem Halbleitermaterial besteht, das es erlaubt, elektronische Signalverarbeitungsschaltungen zu integrieren.

13. Detektor nach einem der Ansprüche 10 oder 11, dadurch gekennzeichnet, daß er zahlreiche Zeilen von supraleitenden Elementen enthält, die eine Matrixstruktur ergeben.

14. Detektor nach Anspruch 1, dadurch gekennzeichnet, daß das supraleitende Material (1) mit einer Schicht aus einem Filtermaterial bedeckt ist, das für eine bestimmte Strahlungsfrequenz oder einen bestimmten Strahlungsfrequenzbereich durchlässig ist.

15. Detektor nach einem der Ansprüche 8 oder 9, dadurch gekennzeichnet, daß die supraleitenden Elemente (1) mit unterschiedlichen Schichten von Filtermaterial bedeckt sind, so daß verschiedene supraleitende Elemente auf unterschiedliche Frequenzen oder Frequenzbereiche ansprechen.

16. Detektor nach Anspruch 13, dadurch gekennzeichnet, daß jede Zeile von supraleitenden Elementen mit einer Schicht eines Filtermaterials einer bestimmten Art bedeckt ist.

17. Detektor nach Anspruch 1, dadurch gekennzeichnet, daß er eine Schicht (15) aus einem für die Strahlung undurchlässigen Material besitzt, die teilweise das supraleitende Element (1) bedeckt und eine Öffnung (16.11 bis 16.n2) besitzt, die auf dem supraleitenden Element eine für die Erfassung der Strahlung empfindliche Zone bestimmt.

18. Detektor nach Anspruch 13, dadurch gekennzeichnet, daß er eine Schicht (15) aufweist, die die Matrixstruktur abdeckt und eine Öffnung (16.11 bis 16.n2) am Ort jedes supraleitenden Elements besitzt.

19. Detektor nach Anspruch 1, dadurch gekennzeichnet, daß das supraleitende Material (1) Übergänge zwischen den Körnern besitzt.

## Claims

1. Radiation detector, characterized in that it comprises:
   - at least one element (1) made of superconducting material having photoresistance properties and sensitive to an illumination inducing a photoresistivity effect in the superconducting material;
   - an electrical source (2) connected to the terminals of the element (1) made of superconducting material;
   - a device for measuring the resistance of the element (1) made of superconducting material connected to this element.

2. Detector according to Claim 1, characterized in that:
   - the electrical source (2) is a constant-voltage source;
   - the device for measuring the resistance of the superconducting element (1) includes a resistive element (3) connected in series with the superconducting element (1) and a voltage-measuring device (4) connected to this resistive element (3) and measuring the voltage at the terminals of the resistive element (3).

3. Detector according to Claim 1, characterized in that:
   - the electrical source (2) is a constant-current source;
   - the device for measuring the resistance of the superconducting element (1) includes a resistive element (5) connected in parallel with the superconducting element (1) and a measuring device (4) coupled to the said resistive element (5) and measuring the current flowing in this resistive element.

4. Detector according to Claim 1, characterized in that:
   - the electrical source (2) is a constant-current source;
   - the differential inputs of a differential amplifier (6, 6', 6") are connected to the terminals of the superconducting element, the amplifier delivering a signal representing the value of the resistance of the superconducting element.

5. Detector according to Claim 1, characterized in that the element (1) made of superconducting material is produced in the form of a layer on a substrate (S).

6. Detector according to Claim 5, characterized in that the element (1) made of superconducting material possesses connections produced as layers on the substrate and in that the resistive elements (3, 5) are also produced as layers on the same substrate (S).

7. Detector according to Claim 6, characterized in that the resistive elements (3, 5) and the connections are produced from superconducting material of the same nature as the element (1) made of superconducting material.

8. Detector according to Claim 1, characterized in that it includes at least one row of elements (1, 1', 1") made of superconducting material which are connected in parallel to the supply outputs of the generator (2) which is then a constant-voltage source, a resistor (3, 3', 3") being associated in series with each element (1, 1', 1") made of superconducting material.

9. Detector according to Claim 1, characterized in that it includes at least one row of elements (1, 1', 1") made of superconducting material which are connected in series and supplied by the generator (2) which is then a constant-current source, a resistor (5, 5,, 5") being associated in parallel with each element (1, 1', 1") made of superconducting material, a device measuring the current flowing in each of these resistors (5, 5', 5").

10. Detector according to one of Claims 8 and 9, characterized in that a charge-coupled device (4) is associated with each set of resistors (3 to 3", 5 to 5") in such a way that a stage (CCD, CCD', CCD") of the charge-coupled device is coupled to each resistor, the association of a resistor and of a stage of the charge-coupled device making it possible to detect the resistance of a superconducting element (1, 1', 1") and consequently to detect the intensity of the radiation received by this superconducting element.

11. Detector according to Claim 4, characterized in that it includes a row of superconducting elements connected in series, a differential amplifier being associated with each superconducting element, and in that it includes a charge-coupled device, one output of each amplifier being connected to one stage of the charge-coupled device which adds the signals delivered by the various differential amplifiers.

12. Detector according to Claim 6, characterized in that the substrate is a semiconductor making it possible to associate electronic signal-processing circuits.

13. Detector according to one of Claims 10 and 11, characterized in that it includes a plurality of rows of superconducting elements so as to constitute a matrix structure.

14. Detector according to Claim 1, characterized in that the element (1) made of superconducting material is covered with a layer of a filtering material which is transparent at a defined radiation frequency or range of frequencies.

15. Detector according to one of Claims 8 and 9, characterized in that the superconducting elements (1) are covered with layers of different filtering material, various superconducting elements thus being sensitive to different frequencies or ranges of frequencies.

16. Detector according to Claim 13, characterized in that each row of superconducting elements is covered by a layer of a filtering material of a defined nature.

17. Detector according to Claim 1, characterized in that it includes a layer (15) of a material opaque to the radiation partially covering the superconducting element (1) and possessing an opening (16.11 to 16.n2) defining a sensitive detection zone on the superconducting element.

18. Detector according to Claim 13, characterized in that it includes a layer 15 covering the matrix structure and possessing an opening (16.11 to 16.n2) at the location of each superconducting element.

19. Detector according to Claim 1, characterized in that the superconducting material (1) possesses intergranular junctions.

# FIG.1

Zone éclairée

a)

# FIG.2

EFFET
BOLOMETRIQUE

I = 5mA

$\Delta V$ (réponse)

$\Delta V(V.\alpha)$

EFFET DU AUX
VORTEX MOBILES

RESISTANCE R

R ($\Omega$)

b)

TEMPERATURE (K)

EP 0 378 459 B1

# FIG.3

# FIG.4

12

# FIG.5

# FIG.6

13

EP 0 378 459 B1

FIG.7

FIG.8

14

EP 0 378 459 B1

# FIG.9

# FIG.10